(19) **Europäisches Patentamt / European Patent Office / Office européen des brevets**

(11) **EP 2 981 836 B1**

(12) **FASCICULE DE BREVET EUROPEEN**

(45) Date de publication et mention
de la délivrance du brevet:
**29.08.2018 Bulletin 2018/35**

(21) Numéro de dépôt: **14720657.7**

(22) Date de dépôt: **03.04.2014**

(51) Int Cl.:
***G01R 29/08*** *(2006.01)*

(86) Numéro de dépôt international:
**PCT/FR2014/050811**

(87) Numéro de publication internationale:
**WO 2014/162104 (09.10.2014 Gazette 2014/41)**

(54) **CHAMBRE REVERBERANTE A UNIFORMITE DE CHAMP ELECTROMAGNETIQUE AMELIOREE**

HALLKAMMER MIT VERBESSERTER ELEKTROMAGNETISCHER FELDGLEICHFÖRMIGKEIT

REVERBERATION CHAMBER WITH IMPROVED ELECTROMAGNETIC FIELD UNIFORMITY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.04.2013 FR 1353001**

(43) Date de publication de la demande:
**10.02.2016 Bulletin 2016/06**

(73) Titulaires:
• **Centre National de la Recherche Scientifique (C.N.R.S.)**
**75016 Paris (FR)**
• **Supelec**
**91190 Gif Sur Yvette Cedex (FR)**
• **Université Paris-Sud 11**
**91405 Orsay Cedex (FR)**

(72) Inventeur: **MONSEF, Florian**
**F-91300 Massy (FR)**

(74) Mandataire: **Lavoix**
**2, place d'Estienne d'Orves**
**75441 Paris Cedex 09 (FR)**

(56) Documents cités:
WO-A1-2011/016109       WO-A1-2012/097732
FR-A1- 2 906 040       US-A1- 2008 056 340
US-A1- 2013 050 006

• RICCARDO STEFANELLI ET AL: "Reduction of electromagnetic interference by means of frequency selective devices", TELECOMMUNICATIONS (ICT), 2010 IEEE 17TH INTERNATIONAL CONFERENCE ON, IEEE, PISCATAWAY, NJ, USA, 4 avril 2010 (2010-04-04), pages 239-243, XP031685445, ISBN: 978-1-4244-5246-0

## Description

### Domaine de l'invention

La présente invention a pour objet une chambre réverbérante comprenant une enceinte blindée constituée d'un plancher, de parois latérales et d'un plafond, et une antenne d'émission d'ondes radio-fréquences pour engendrer à l'intérieur de l'enceinte un rayonnement à une fréquence minimale d'utilisation.

### Art antérieur

Les chambres réverbérantes à brassage de modes sont des moyens d'essai de compatibilité électromagnétique qui comprennent une enceinte blindée formant cage de Faraday à l'intérieur de laquelle on introduit un appareil à tester. On exploite les modes de résonance de la cavité définie par l'enceinte.

Une chambre réverbérante permet ainsi entre autres de tester un équipement électrique afin de connaître l'influence que peuvent avoir des rayonnements électromagnétiques environnants sur cet équipement électrique ou à l'inverse, de déterminer l'énergie électromagnétique émise par l'équipement électrique dans son environnement.

Aujourd'hui le brassage de modes est ainsi essentiellement fait dans le domaine des microondes dans le cadre de mesures de tests et d'essai en compatibilité électromagnétique (CEM). Ces moyens de tests qui s'effectuent en chambre réverbérante sont régis par la norme 61000-4-21 de la Commission Internationale de l'Electrotechnique.

Le brassage permet d'assurer une uniformité statistique du champ et s'effectue à fréquence fixe. La technique mécanique est basée sur l'utilisation d'un brasseur de modes comprenant une pale métallique rotative qui a pour but de modifier les conditions aux limites. Cette pale peut être utilisée en mode de rotation pas à pas ou en mode de rotation continue. Ce dernier mode a pour but d'accélérer la procédure de brassage. La vitesse est toutefois limitée afin d'assurer un régime stationnaire.

Une chambre réverbérante admet une fréquence minimale dénotée LUF (LUF pour "Lowest Usable Frequency" en anglais) à laquelle on associe un recouvrement modal noté ici N1.

Dans le cas d'une chambre réverbérante métallique à dimensions fixes, il a déjà été proposé une technique permettant l'amélioration locale de l'uniformité du champ électromagnétique et l'abaissement de la LUF. Celle-ci nécessite l'insertion d'antennes supplémentaires fixées aux parois ainsi que l'utilisation d'un générateur arbitraire coûteux. Le principe est basé sur la synthèse de signaux (arbitraires) injectés dans les différentes antennes. L'idée est d'exciter les modes habituellement trop atténués dans une configuration classique afin d'augmenter artificiellement le nombre de modes excités, c'est-à-dire le recouvrement modal, et parvenir ainsi à obtenir une uniformité statistique du champ électromagnétique y compris à une fréquence inférieure à la LUF. Pour plus de détails sur cette technique connue, on peut se référer à un article de Cozza et al. - Symposium on Electromagnetic Compatibility (APEMC), 2012 Asia-Pacific, pp. 765-768 (Ref 1). Les documents US2013/0050006, WO2012/097732 et FR2906040 divulguent d'autres chambres réverbérantes.

### Définition et objet de l'invention

La présente invention vise à remédier aux inconvénients précités et à permettre d'améliorer l'uniformité du champ électromagnétique dans une chambre réverbérante tout en offrant également la possibilité d'abaisser la fréquence minimale d'utilisation d'une chambre réverbérante.

L'invention vise également à obtenir ces résultats avec des matériaux et composants peu coûteux.

Ces buts sont atteints, conformément à l'invention, grâce à une chambre réverbérante à uniformité de champ électromagnétique améliorée, comprenant une enceinte blindée constituée d'un plancher, de parois latérales et d'un plafond, et une antenne d'émission d'ondes radio-fréquences pour engendrer à l'intérieur de l'enceinte un rayonnement à une fréquence minimale d'utilisation, caractérisée en ce qu'elle comprend en outre à l'intérieur de l'enceinte un ensemble d'éléments passifs et sélectifs d'absorption de radiofréquences dans une bande de fréquences définie ayant une borne supérieure qui est ladite fréquence minimale d'utilisation de la chambre réverbérante et en ce que les éléments passifs et sélectifs d'absorption de radiofréquences sont disposés à une distance des parois latérale de l'enceinte qui est au moins égale à la moitié de la longueur d'onde correspondant à ladite fréquence minimale d'utilisation de la chambre réverbérante.

La chambre réverbérante comprend un brasseur de modes de résonance à l'intérieur de l'enceinte.

De façon plus particulière, les éléments passifs et sélectifs d'absorption de radiofréquences comprennent des matériaux composites artificiels dont les propriétés de coefficient de transmission sont sélectives en fréquence.

Selon un mode de réalisation particulier, les éléments passifs et sélectifs d'absorption de radiofréquences comprennent des réseaux à structure périodique, dont la taille des motifs élémentaires est de l'ordre de la demi-longueur d'onde de la fréquence d'absorption souhaitée.

Selon un autre mode de réalisation particulier, les éléments passifs et sélectifs d'absorption de radiofréquences comprennent des méta-matériaux comportant des matrices de motifs.

Selon un autre mode de réalisation particulier, les éléments passifs et sélectifs d'absorption de radiofréquences comprennent un absorbant encapsulé dans des empilements de réseaux à structure périodique ou des méta-matériaux.

Pour les méta-matériaux, les motifs peuvent être des gravures en matériau métallique conducteur tel que du cuivre ou de l'aluminium, sur un matériau diélectrique et présentent de préférence une taille qui est de l'ordre du dixième d'une longueur d'onde correspondant à ladite fréquence minimale d'utilisation.

Dans le cas d'un empilement, cet empilement peut comprendre deux ou trois couches superposées et les réseaux à structure périodique ou les méta-matériaux peuvent comprendre des motifs constitués par des anneaux circulaires ou carrés.

La fréquence minimale d'utilisation est de préférence comprise entre 100 MHz et 18 GHz.

L'absorbant peut être une mousse absorbante dans le domaine des micro-ondes, telle que celle constituée d'uréthane.

Selon un mode particulier de réalisation, les éléments passifs et sélectifs d'absorption de radiofréquences se comportent comme des filtres passe-bas à l'échelle des bandes de fréquence considérées.

Les éléments passifs et sélectifs d'absorption de radiofréquences peuvent également constituer un filtre spatial passe-bande.

Selon l'invention, on insère ainsi dans une chambre réverbérante (CR) un absorbant sélectif en fréquence (ASF) qui est un type d'absorbant permettant d'insérer localement des pertes, c'est-à-dire d'insérer des pertes sur une bande de fréquences donnée. Une conséquence directe est une amélioration (locale et donc sélective) du recouvrement modal.

L'augmentation de ce recouvrement modal a pour effet d'améliorer l'uniformité statistique du champ électromagnétique (EM) au sein de la chambre réverbérante à une fréquence donnée.

Selon une réalisation préférentielle, si l'on considère que la bande de fréquence de l'absorbant sélectif en fréquence admet comme borne supérieure la LUF, l'insertion de l'absorbant sélectif en fréquence permet alors une augmentation du recouvrement modal. Le recouvrement modal N1 est alors observé à une fréquence inférieure à la LUF classique, ce qui signifie que l'on a ainsi diminué la fréquence minimale d'utilisation de la chambre réverbérante.

Selon un mode de réalisation particulier, les éléments passifs et sélectifs d'absorption de radiofréquences comprennent des structures en deux dimensions qui ne sont parallèles à aucune des faces de la chambre réverbérante constituées par le plancher, les parois latérales et le plafond .

Selon un autre mode de réalisation particulier, les éléments passifs et sélectifs d'absorption de radiofréquences comprennent des structures en trois dimensions.

Avantageusement, les éléments passifs et sélectifs d'absorption de radiofréquences sont disposé à l'intérieur de l'enceinte dans une zone centrale éloignée des parois latérales et du plafond.

Brève description des dessins

D'autres caractéristiques et avantages de l'invention ressortiront de la description suivante de modes particuliers de réalisation de l'invention donnés à titre d'exemples en référence aux dessins annexés, sur lesquels :

- La Figure 1 représente une vue schématique d'une chambre réverbérante selon la présente invention,
- La Figure 2 montre un exemple de surface sélective en fréquence à motifs carrés agencés périodiquement de manière à constituer un filtre passe-bas, à l'échelle des bandes de fréquences considérées,
- La Figure 3 montre une courbe illustrant la réponse en fréquence de la surface sélective en fréquence illustrée sur la figure 2,
- La Figure 4 montre un exemple d'empilement de couches absorbantes se comportant comme un filtre passe-bande,
- La Figure 5 montre un exemple de structure de type réjecteur de bande,
- La Figure 6 montre un exemple de structure absorbante à plusieurs fréquences,
- La Figure 7 représente une vue schématique d'une chambre réverbérante selon la présente invention, d'une façon analogue à la Figure 1, mais avec des localisations différentes pour les éléments placés à l'intérieur de cette chambre,
- La Figure 8A est une vue en perspective d'un exemple particulier de structure absorbante en trois dimensions, et
- La Figure 8B est une vue éclatée de la structure de la Figure 8A.

Description détaillée de modes de réalisation préférentiels

La technique proposée selon l'invention permet l'amélioration locale de l'uniformité du champ EM avec une possibilité optionnelle et préférentielle d'abaissement de la LUF.

Cette technique présente deux avantages majeurs sur les techniques de l'art antérieur rappelées plus haut. Le premier avantage est qu'elle est purement passive, c'est-à-dire ne nécessite pas de générateur additionnel autre que celui classiquement utilisé dans une chambre réverbérante. Le deuxième avantage est qu'il s'agit d'un objet transportable sans aucune contrainte spécifique de placement au sein de la chambre réverbérante.

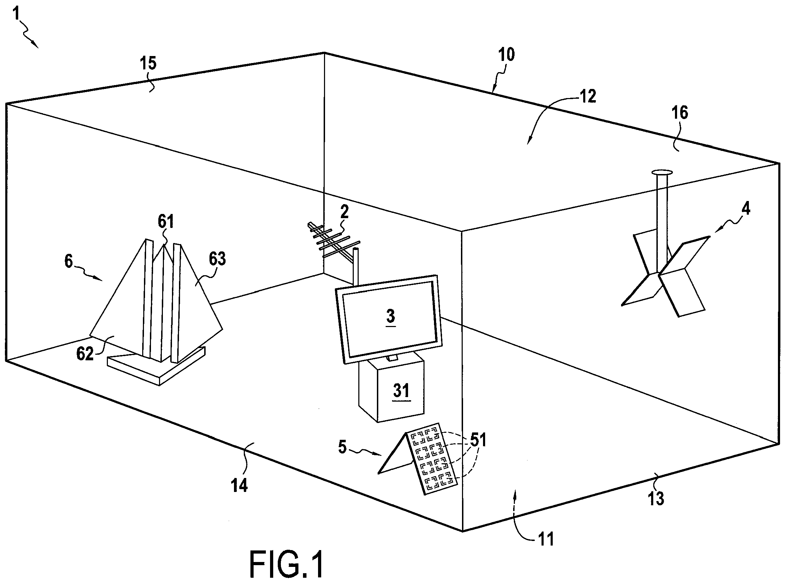

Un exemple de placement d'absorbants sélectifs en fréquence est donné figure 1 dans une chambre réverbérante à brassage de modes 1 comprenant une enceinte 10 blindée constituée d'un plancher 11, de parois latérales 13 à 16 et d'un plafond 12.

On a représenté à l'intérieur de la chambre réverbérante un objet sous test 3, qui peut être par exemple un téléviseur ou tout autre type d'appareil électrique ou électronique, placé sur un support 31. Une antenne d'émission 2 d'ondes radio-fréquences permet d'engendrer à l'intérieur de l'enceinte 10 un rayonnement à une fréquence minimale d'utilisation (LUF) pour des tests de susceptibilité. Un brasseur 4 assure le brassage de modes souhaité.

La figure 1 montre également deux absorbants sélectifs passifs 5 et 6 placés à l'intérieur de l'enceinte 10 et obtenus par deux techniques différentes qui seront décrites ci-après.

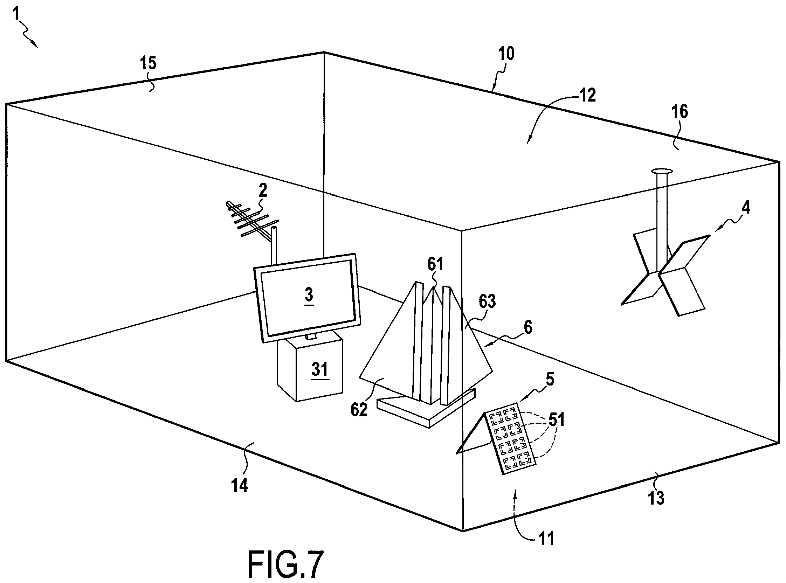

La figure 7 montre un autre exemple de positionnement des éléments à l'intérieur de la chambre réverbérante. Ainsi, sur la figure 7, on voit un absorbant sélectif passif 6 qui est placé dans une zone centrale éloignée des parois latérales 13 à 16 ainsi que du plafond 12 en étant simplement posé sur le plancher 11. De même un absorbant sélectif passif 5 est également situé à une certaine distance des parois latérales 13 à 16. Compte tenu de la faible taille des absorbants sélectifs passifs, l'objet sous test 3 et l'antenne d'émission 2 peuvent coexister avec ces absorbants sélectifs passifs 5 et 6 dans la zone centrale ou en limite de la zone centrale.

La localisation au centre de la chambre 1 des absorbants sélectifs passifs 5 et 6 permet d'utiliser des structures portables de petites dimensions. En outre, selon l'invention, les résonances de la chambre ne sont pas dégradées de façon trop importante afin de maintenir une intensité de champ qui notamment soit compatible avec le standard IEC-61000-4-21.

Selon l'invention, on reste ainsi dans une approximation à faibles pertes, c'est-à-dire que l'on contribue d'une part à améliorer le recouvrement modal grâce aux pertes insérées (diminution de la LUF) et d'autre part à assurer des niveaux de champ suffisamment intense pour pouvoir effectuer des tests d'immunité sur un objet 3.

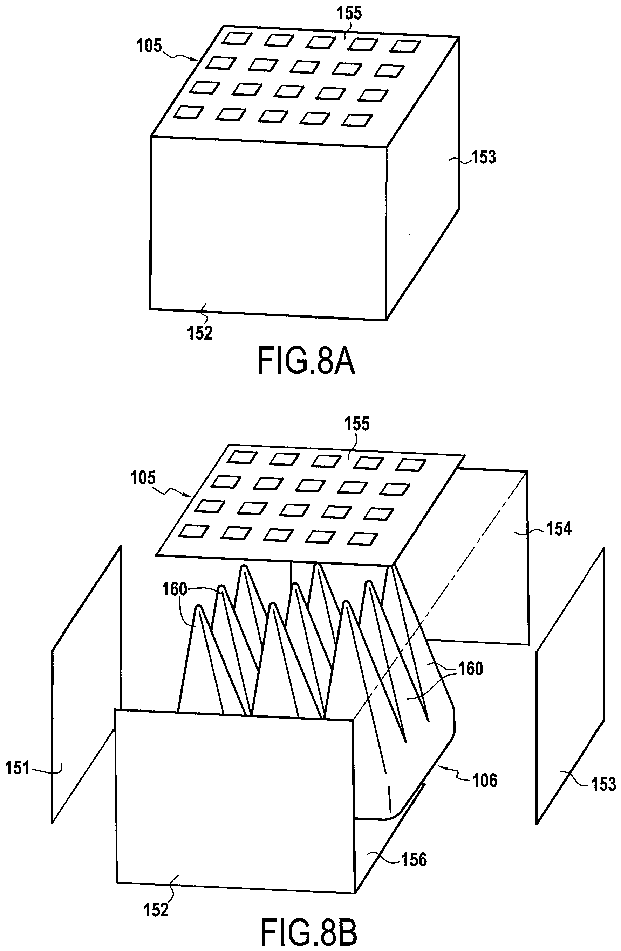

Il est à noter que, sur les figures 1 et 7, on a représenté la mise en oeuvre simultanée de deux types différents d'absorbants sélectifs passifs 5 et 6, mais il est naturellement possible de mettre en oeuvre l'invention en utilisant un seul de ces deux types d'absorbants sélectifs passifs 5 et 6. Il est également possible de combiner en une structure unique ces deux types d'absorbants sélectifs passifs 5 et 6. Un mode particulier de réalisation de structures combinées sera indiqué plus loin en référence aux figures 8A et 8B.

L'invention est basée sur des matériaux composites artificiels dont la propriété de coefficient de transmission est sélective en fréquence.

La proposition détaillée ici est basée sur l'utilisation de réseaux à structures périodiques classiques, dénommés surfaces sélectives en fréquence (SSF), et/ou de méta-matériaux. Ces derniers sont également à structures périodiques mais ils permettent de réaliser des permittivités et/ou perméabilités négatives et sont généralement constitués de motifs de taille plus réduite, typiquement de l'ordre de λ/10, c'est-à-dire de l'ordre du dixième de la longueur d'onde correspondant à la LUF. Par conséquent, pour des raisons d'encombrement directement lié à la taille des motifs, il sera préférable d'avoir recours aux méta-matériaux pour des fréquences inférieures au GHz.

Il est important de souligner que n'importe quel autre procédé permettant d'obtenir un matériau sélectif en fréquence est envisageable et entre dans le cadre de la méthode proposée. En conséquence, les exemples cités dans la présente demande sont donnés à titre d'exemples et démontrent la faisabilité de l'invention, mais ne doivent pas être considérés comme exhaustifs.

La première méthode proposée ici consiste à considérer la mise en oeuvre de ladite invention par l'utilisation d'un absorbant encapsulé 6.

L'absorbant proprement dit 61, ou matériau A (qui peut être de l'uréthane par exemple), large bande inclut la LUF dans son domaine de fréquences. L'idée est de réduire la plage de fréquences sur laquelle l'absorbant sera « vu » par des ondes EM.

Il est important de noter que la volonté de réduire cette plage de fréquences n'est pas anodine. En effet, on rappelle que l'utilisation de la chambre réverbérante porte entre autres sur l'exploitation des résonances de la cavité 10 pour obtenir des niveaux de champ EM intenses, très utiles dans les tests de susceptibilité EM. L'insertion de pertes à des fréquences où le recouvrement modal est déjà suffisant n'est donc pas bénéfique dans la mesure où l'on réduit l'effet des résonances, et donc le niveau des champs maximaux, sans pour autant améliorer l'uniformité du champ EM.

On comprend alors l'intérêt de réduire la plage. Pour ce faire, une technique possible est d'encapsuler l'absorbant 61 par des éléments 62, 63 constitués par des surfaces sélectives en fréquence (SSF) ou des empilements de méta-matériaux dont le coefficient de transmission global est « plat » sur une bande de fréquences ΔF.

Chaque élément de l'empilement sera conçu pour travailler sur une bande de fréquences donnée. La taille maximale des motifs constituant le méta-matériau ainsi que la taille maximale des panneaux de méta matériaux est dictée en première approximation par la LUF. Une dimension typique d'une demi-longueur d'onde des panneaux est à considérer et d'un dixième de longueur d'onde pour les motifs.

A titre d'exemple, une chambre réverbérante de 13 mètres cubes peut admettre une LUF autour de 500 MHz. Il s'ensuit des panneaux de 30 cm avec des motifs de l'ordre de 6 cm. Plus généralement, pour une LUF de valeur fLUF, la dimension lmax maximale d'une plaque de type polygone est alors telle que,

$$lmax = c/(2*fLUF).$$

Le type de polygone n'est ici pas précisé, car la forme exacte des surfaces sélectives n'est pas contraignante. Celle-ci sera plutôt dictée par la forme des absorbants eux-mêmes.

D'un point de vue phénoménologique, il s'ensuit qu'une onde incidente dont la fréquence appartient à ΔF sera transmise par le méta matériau à l'absorbant central. Les pertes découlant de cet absorbant se traduisent par un abaissement du facteur de qualité de la chambre réverbérante à la fréquence considérée et donc à un élargissement des réponses fréquentielles des modes (inclus dans la bande ΔF) de la cavité. Cet élargissement a pour effet de pouvoir exciter ce mode sur une bande de fréquences plus large. Si plusieurs modes inclus dans ΔF sont dans ce cas de figure (et tel est le cas), on parvient ainsi à exciter plus de modes à une fréquence fixe qu'en l'absence du matériau B. On rappelle que l'antenne émettrice dans une chambre réverbérante utilisée dans le cadre de la norme IEC 61000-4-21 est censée être excitée en régime sinusoïdal, c'est-à-dire à fréquence fixe.

A contrario, si la fréquence de l'onde incidente n'appartient pas à ΔF, l'onde sera réfléchie par le méta-matériau et les pertes du matériau A ne seront pas ressenties. En d'autres termes, la chambre réverbérante fonctionnera classiquement.

Le succès de la technique est d'autant meilleur que l'anisotropie des méta-matériaux est faible, c'est-à-dire que le comportement des surfaces sélectives en fréquence ou des méta-matériaux ne dépend pas de l'angle d'incidence de l'onde et de la polarisation de l'onde. De tels matériaux existent à l'heure actuelle, comme indiqué par exemple dans un article de Zhou et al., Phys. Rev. Lett.94, 243905 (Ref. 2) ou encore dans un article de Huang-L. et al, Progress In Electromagnetics Research, vol.113, pp.103-110, 2011 (Ref 3).

La technique détaillée n'est pas exhaustive. Elle présente néanmoins un avantage considérable en ce qui concerne le coût puisque les méta-matériaux utilisés dans les bandes de fréquences considérées sont, basiquement, des motifs en cuivre 71 sur un diélectrique de type FR4 (composite de résine epoxy renforcé de fibres de verre) ou Duroid (composite de PTFE renforcé de micro-fibres de verre).

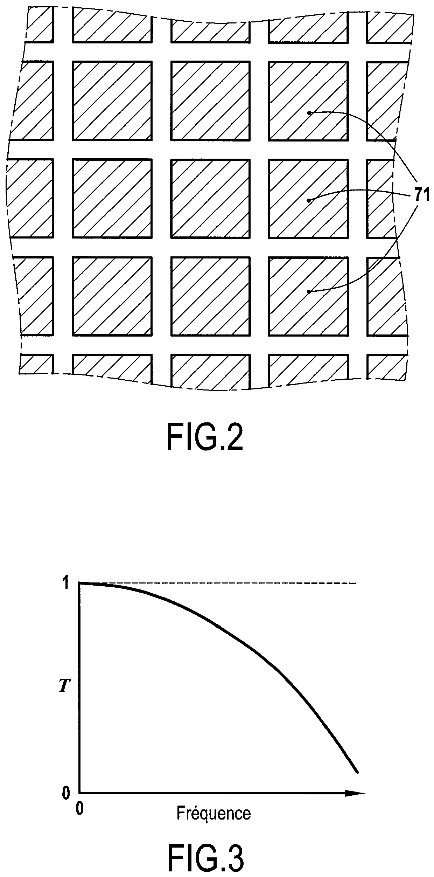

Le choix des motifs et de la structure globale dépend du type de filtre souhaité. Pour un abaissement de la LUF, un filtre de type passe-bas à l'échelle des bandes de préférence considérées est souhaitable. Une structure classique consiste dans ce cas à prendre des motifs 71 carrés agencés périodiquement, comme montré figure 2. La réponse en fréquence obtenue pour ce dimensionnement est illustrée figure 3.

L'intérêt de l'invention ne se cantonne pas à la réduction possible de la LUF. Pour en comprendre la raison, on présentera quelques rappels. Le recouvrement modal dépend des pertes et de la densité modale. Ces deux quantités sont, en moyenne, croissantes avec la fréquence. Toutefois, sur une bande de fréquences donnée le recouvrement modal résultant peut être très fluctuant. Ces fluctuations peuvent induire, notamment à des fréquences supérieures à la LUF, une uniformité de champ EM non satisfaisante ou au contraire très satisfaisante. Cette disparité de scénario est évidemment d'autant plus probable pour des zones de fréquences proches de la LUF, mais supérieures à celle-ci.

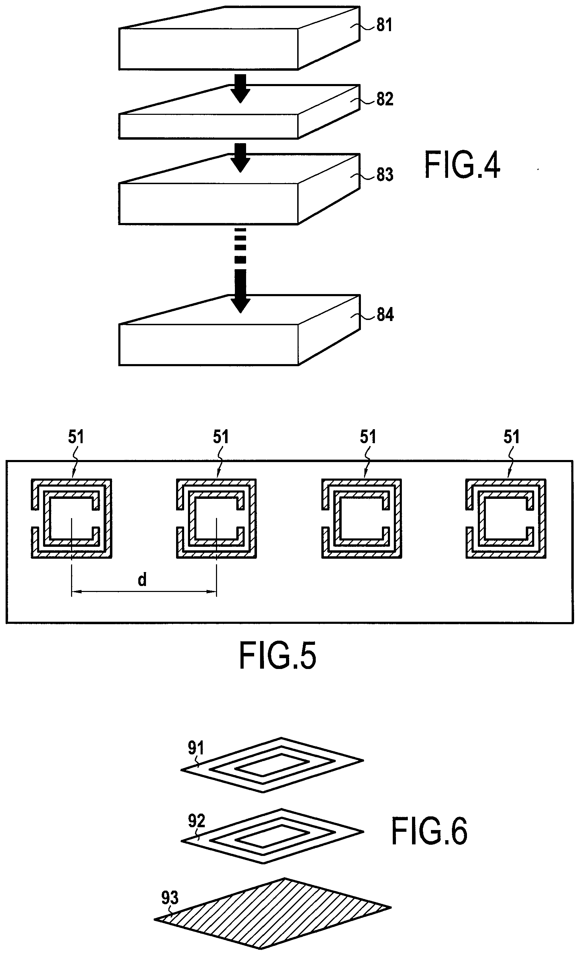

Ainsi pour un absorbant B conçu pour ces zones de fréquences, on assurera une uniformité plus probable et donc, une augmentation de fiabilité des méthodes de tests. Dans ce cas de figure, un comportement de type passe-bande est à envisager, afin que l'absorbant n'agisse que dans une plage de fréquences définie. Un exemple de couches 81 et 83 de matériau A enserrant une couche 82 de matériau B pour former un filtre spatial passe-bande 84 est représenté sur la figure 4, le détail de la réalisation des couches étant donné dans la Ref. 3 pré-citée.

La deuxième méthode consiste à s'affranchir de l'utilisation de mousse absorbante en utilisant des SSF et/ou méta-matériaux de type réjecteur de bande (cf l'article de Gay-Balmaz-P. et al., J. Appl. Phys 92 (5), pp.2929-2936, 2002 (Ref.4)), qui seront directement placés au sein de la chambre réverbérante comme montré par l'élément 5 de la figure 1.

Une distance d'au moins une demi-longueur d'onde est souhaitable entre l'absorbant sélectif en fréquence et la paroi verticale la plus proche. L'utilisation de ce type de dispositif est a priori plus adaptée à l'amélioration locale de la densité modale. Une utilisation pour un abaissement de la LUF n'est toutefois pas à exclure. Un exemple d'une telle structure est donné figure 5 où l'on voit des motifs 51 avec deux anneaux carrés imbriqués l'un dans l'autre et présentant chacun une interruption de faible longueur qui réduit fortement la fréquence de résonance du système. Les centres de deux motifs successifs sont écartés d'une distance d. D'autres types de motifs sont exploitables.

Un dimensionnement de surfaces sélectives en fréquence est détaillé dans un article "Frequency Selective Surface and Grid Array", WU-T.K., Wiley, 1995 (Ref. 5). Il est à noter que l'utilisation de surfaces sélectives en fréquence est d'autant plus appropriée que les fréquences, pour lesquelles on désire améliorer l'absorption, sont élevées, et ce pour des raisons d'encombrement. Cela concerne typiquement les chambres réverbérantes de petite taille dont le volume est de l'ordre de quelques mètres cube.

Dans le cas où les fréquences sont typiquement inférieures au GigaHertz, il est préférable d'opter pour des méta-matériaux. Il peut être également souhaitable d'avoir des absorptions à plusieurs fréquences. Un exemple de réalisation est donné figure 6 avec des superpositions de motifs : motif haut 91, motif central 92 et motif bas 93, l'écartement entre les motifs superposés pouvant par exemple être de 0,5 mm. Le détail du dimensionnement est donné dans la Ref. 3 pré-citée. Une première couche de matériau diélectrique est intercalée entre le motif haut 91 et le motif central 92 en cuivre qui comprennent chacun trois anneaux carrés concentriques. Une deuxième couche de matériau diélectrique est intercalée entre le motif central 92 et le motif bas 93 qui comprend une surface carrée remplie de cuivre.

D'une manière générale, l'invention concerne une technique et/ou un objet basés sur des matériaux passifs et facilement portables. En outre elle est basée sur l'utilisation de matériaux et composants peu onéreux.

Bien que la zone de fréquence proche de la LUF soit utilisable d'après la norme, elle implique des variances du champ trop importantes (c'est-à-dire une mauvaise uniformité de champ). La physique des cavités explique très bien cette probabilité d'écart à la loi.

La présente invention permet d'améliorer l'uniformité du champ dans cette zone de fréquences, réduisant ainsi cette probabilité de mauvaise uniformité.

D'un point de vue pratique, on peut ainsi envisager différents modèles sur étagère. Ces modèles auront deux caractéristiques principales : le niveau de pertes inséré et la bande de fréquences d'opération.

Un utilisateur ou un constructeur de chambre réverbérante pourra acquérir le modèle adapté aux caractéristiques de sa chambre (dimensions, niveau de pertes, valeur de la LUF,...) afin d'une part d'améliorer l'uniformité du champ EM dans les zones sensibles, c'est-à-dire pour des fréquences supérieures à la LUF et/ou d'autre part d'abaisser la LUF.

La technique « concurrente » connue nécessite une insertion d'antennes dans les chambres réverbérantes et un générateur arbitraire coûteux. En outre, la participation de modes habituellement peu excités suppose un rendement global très bas. On entend par rendement le rapport entre l'énergie du champ EM au sein de la chambre réverbérante et l'énergie des signaux arbitraires à envoyer dans les diverses antennes.

Sur le plan des réalisations pratiques, l'invention implique une reproductibilité égale à celle des circuits imprimés actuels avec une complexité de réalisation bien moindre que les cartes électroniques actuelles. L'ordre de grandeur de la taille d'un absorbant 5 ou 6 selon l'invention peut correspondre par exemple à celle d'une carte grand format de 40*60 cm, avec une masse de 1kg maximum. La taille des absorbants encapsulés 6 dépend toutefois essentiellement de la fréquence à laquelle on souhaite améliorer l'uniformité.

Les éléments passifs et sélectifs d'absorption de radiofréquences peuvent comprendre des structures en deux dimensions qui ne sont parallèles à aucune des faces de la chambre réverbérante constituées par ledit plancher 11, les parois latérales 13 à 16 et le plafond 12 (voir les éléments 5 et 6 des figures 1 et 7).

Les éléments passifs et sélectifs d'absorption de radiofréquences peuvent également comprendre des structures en trois dimensions, par exemple pyramidales ou coniques.

On a représenté sur les figures 8A et 8B un exemple de structure en trois dimensions qui combine un ensemble 106 d'éléments absorbants passifs 160, par exemple en mousse et pouvant présenter des formes coniques, et une boîte extérieure 105 comportant une face supérieure 155 munie de motifs métalliques formés sur une surface en matériau diélectrique comme indiqué plus haut, des parois métalliques latérales 151 à 154 et un fond 156. La plaque 155 munie de motifs peut être parallèle à l'une des parois (par exemple le plafond 12) de la chambre réverbérante 1, mais se présente sous la forme d'un couvercle de boîte 105 à l'intérieur de laquelle est disposé un ensemble 106 de cônes 160 en mousse dont les dimensions sont en adéquation avec la bande de longueur d'onde où l'on souhaite l'absorption. A titre de variante, il est aussi possible de réaliser une boîte extérieure 105 qui soit positionnée dans la chambre réverbérante de telle manière que la plaque 155 munie de motifs ne soit parallèle à aucune des parois de la chambre réverbérante.

## Revendications

1. Chambre réverbérante à uniformité de champ électromagnétique améliorée, comprenant une enceinte (10) blindée constituée d'un plancher (11), de parois latérales (13 à 16) et d'un plafond (12), et une antenne d'émission (2) d'ondes radio-fréquences pour engendrer à l'intérieur de l'enceinte (10) un rayonnement à une fréquence minimale d'utilisation, **caractérisée en ce qu'**elle comprend en outre à l'intérieur de l'enceinte (10) un ensemble (5, 6) d'éléments passifs et sélectifs d'absorption de radiofréquences dans une bande de fréquences définie ayant une borne supérieure qui est ladite fréquence minimale d'utilisation de la chambre réverbérante et **en ce que** les éléments passifs et sélectifs d'absorption de radiofréquences sont disposés à une distance des parois latérales (13 à 16) de l'enceinte (10) qui est au moins égale à la moitié de la longueur d'onde correspondant à ladite fréquence minimale d'utilisation de la chambre réverbérante.

2. Chambre réverbérante selon la revendication 1, **caractérisée en ce qu'**elle comprend un brasseur (4) de modes de résonance à l'intérieur de l'enceinte (10).

3. Chambre réverbérante selon l'une quelconque des revendications 1 et 2, **caractérisée en ce que** les éléments passifs et sélectifs d'absorption de radiofréquences comprennent des matériaux composites artificiels dont les propriétés de coefficient de transmission sont sélectives en fréquence.

4. Chambre réverbérante selon la revendication 3, **caractérisée en ce que** les éléments passifs et sélectifs d'absorption de radiofréquences (5) comprennent des réseaux à structure périodique dont la taille des motifs élémentaires est de l'ordre de la demi-longueur d'onde de la fréquence d'absorption souhaitée.

**5.** Chambre réverbérante selon la revendication 3, **caractérisée en ce que** les éléments passifs et sélectifs d'absorption de radiofréquences (5) comprennent des méta-matériaux comportant des matrices de motifs (51).

**6.** Chambre réverbérante selon l'une quelconque des revendications 1 à 5, **caractérisée en ce que** les éléments passifs et sélectifs d'absorption de radiofréquences comprennent un absorbant (61) encapsulé dans des empilements (62, 63) de réseaux à structure périodique ou des méta-matériaux.

**7.** Chambre réverbérante selon la revendication 5, **caractérisée en ce que** les motifs (51) sont des gravures en un matériau métallique conducteur sur un matériau diélectrique et présentent une taille qui est de l'ordre du dixième d'une longueur d'onde correspondant à ladite fréquence minimale d'utilisation.

**8.** Chambre réverbérante selon la revendication 6, **caractérisée en ce que** ledit empilement comprend deux ou trois couches (61 à 63) superposées et les réseaux à structure périodique ou les méta-matériaux comprennent des motifs constitués par des anneaux circulaires ou carrés.

**9.** Chambre réverbérante selon l'une quelconque des revendications 1 à 8, **caractérisée en ce que** ladite fréquence minimale d'utilisation est comprise entre 100 MHz et 18 GHz.

**10.** Chambre réverbérante selon la revendication 6, **caractérisée en ce que** l'absorbant (61) comprend une mousse absorbante dans le domaine des micro-ondes.

**11.** Chambre réverbérante selon la revendication 4 ou la revendication 5, **caractérisée en ce que** les éléments passifs et sélectifs d'absorption de radiofréquences se comportent comme des filtres passe-bas, à l'échelle des bandes de fréquences considérées.

**12.** Chambre réverbérante selon l'une quelconque des revendications 1 à 10, **caractérisée en ce que** les éléments passifs et sélectifs d'absorption de radiofréquences constituent un filtre spatial passe-bande.

**13.** Chambre réverbérante selon l'une quelconque des revendications 1 à 12, **caractérisée en ce que** les éléments passifs et sélectifs d'absorption de radiofréquences comprennent des structures en deux dimensions qui ne sont parallèles à aucune des faces de la chambre réverbérante constituées par ledit plancher (11), lesdites parois latérales (13 à 16) et ledit plafond (12).

**14.** Chambre réverbérante selon l'une quelconque des revendications 1 à 12, **caractérisée en ce que** les éléments passifs et sélectifs d'absorption de radiofréquences comprennent des structures en trois dimensions (106).

**15.** Chambre réverbérante selon l'une quelconque des revendications 1 à 14, **caractérisée en ce que** les éléments passifs et sélectifs d'absorption de radiofréquences sont disposés à l'intérieur de l'enceinte (10) dans une zone centrale éloignée desdites parois latérales (13 à 16) et dudit plafond (12).

**Patentansprüche**

**1.** Hallraum mit verbesserter elektromagnetischer Feldgleichmäßigkeit, aufweisend einen abgeschirmten abgeschlossenen Raum (10), der aus einem Boden (11), Seitenwänden (13 bis 16) und einer Decke (12) gebildet ist, und eine Antenne (2) zum Senden von Radiofrequenzwellen, um im Inneren des abgeschlossenen Raumes (10) eine Strahlung mit einer minimalen Nutzfrequenz zu erzeugen, **dadurch gekennzeichnet, dass** er ferner im Inneren des abgeschlossenen Raumes (10) einen Satz (5, 6) passiver und selektiver Elemente zur Absorption von Radiofrequenzen in einem definierten Frequenzband mit einer oberen Grenze aufweist, die die minimale Nutzfrequenz des Hallraumes ist, und dass die passiven und selektiven Elemente zur Absorption von Radiofrequenzen in einem Abstand von den Seitenwänden (13 bis 16) des abgeschlossenen Raumes (10) angeordnet sind, der mindestens gleich der Hälfte der Wellenlänge ist, die der minimalen Nutzfrequenz des Hallraumes entspricht.

**2.** Hallraum gemäß Anspruch 1, **dadurch gekennzeichnet, dass** er im Inneren des abgeschlossenen Raumes (10) einen Resonanzmodenrührer (4) aufweist.

**3.** Hallraum gemäß irgendeinem der Ansprüche 1 und 2, **dadurch gekennzeichnet, dass** die passiven und selektiven Elemente zur Absorption von Radiofrequenzen synthetische Verbundmaterialien aufweisen, deren Übertragungskoeffizient-Eigenschaften frequenzselektiv sind.

**4.** Hallraum gemäß Anspruch 3, **dadurch gekennzeichnet, dass** die passiven und selektiven Elemente zur Absorption von Radiofrequenzen (5) Anordnungen mit periodischer Struktur aufweisen, deren Grundmustergröße in der Größenordnung der Halbwellenlänge der gewünschten Absorptionsfrequenz ist.

5. Hallraum gemäß Anspruch 3, **dadurch gekennzeichnet, dass** die passiven und selektiven Elemente zur Absorption von Radiofrequenzen (5) Metamaterialien aufweisen, die Mustermatrizen (51) aufweisen.

6. Hallraum gemäß irgendeinem der Ansprüche 1 bis 5, **dadurch gekennzeichnet, dass** die passiven und selektiven Elemente zur Absorption von Radiofrequenzen einen Absorber (61) aufweisen, der in Stapeln (62, 63) von Anordnungen mit periodischer Struktur oder Metamaterialien eingekapselt ist.

7. Hallraum gemäß Anspruch 5, **dadurch gekennzeichnet, dass** die Muster (51) Ätzungen in einem leitfähigen Metallmaterial auf einem dielektrischen Material sind und eine Größe haben, die in der Größenordnung des Zehntels einer Wellenlänge liegt, die der minimalen Nutzfrequenz entspricht.

8. Hallraum gemäß Anspruch 6, **dadurch gekennzeichnet, dass** der Stapel zwei oder drei übereinander angeordnete Schichten (61 bis 63) aufweist, und die Anordnungen mit periodischer Struktur oder die Metamaterialien Muster aufweisen, die aus kreisförmigen oder quadratischen Ringen gebildet sind.

9. Hallraum gemäß irgendeinem der Ansprüche 1 bis 8, **dadurch gekennzeichnet, dass** die minimale Nutzfrequenz zwischen 100 MHz und 18 GHz beträgt.

10. Hallraum gemäß Anspruch 6, **dadurch gekennzeichnet, dass** der Absorber (61) einen im Mikrowellenbereich absorbierenden Schaumstoff aufweist.

11. Hallraum gemäß Anspruch 4 oder Anspruch 5, **dadurch gekennzeichnet, dass** sich die passiven und selektiven Elemente zur Absorption von Radiofrequenzen wie Tiefpassfilter im Bereich der berücksichtigten Frequenzbänder verhalten.

12. Hallraum gemäß irgendeinem der Ansprüche 1 bis 10, **dadurch gekennzeichnet, dass** die passiven und selektiven Elemente zur Absorption von Radiofrequenzen ein räumliches Bandpassfilter bilden.

13. Hallraum gemäß irgendeinem der Ansprüche 1 bis 12, **dadurch gekennzeichnet, dass** die passiven und selektiven Elemente zur Absorption von Radiofrequenzen zweidimensionale Strukturen aufweisen, die zu keiner der Seiten des Hallraumes parallel sind, die durch den Boden (11), die Seitenwände (13 bis 16) und die Decke (12) gebildet sind.

14. Hallraum gemäß irgendeinem der Ansprüche 1 bis 12, **dadurch gekennzeichnet, dass** die passiven und selektiven Elemente zur Absorption von Radiofrequenzen dreidimensionale Strukturen (106) aufweisen.

15. Hallraum gemäß irgend einem der Ansprüche 1 bis 14, **dadurch gekennzeichnet, dass** die passiven und selektiven Elemente zur Absorption von Radiofrequenzen im Inneren des geschlossenen Raumes (10) in einem zentralen Bereich angeordnet sind, der von den Seitenwänden (13 bis 16) und der Decke (12) entfernt ist.

**Claims**

1. Reverberation chamber with improved electromagnetic field uniformity, comprising a shielded enclosure (10) composed of a floor (11), side walls (13 to 16) and a ceiling (12), and an antenna (2) for emitting radiofrequency waves in order to generate inside the enclosure (10) radiation at a lowest usable frequency, **characterised in that** it further comprises, inside the enclosure (10), a set (5, 6) of passive and selective elements for absorbing radiofrequencies in a defined frequency band having an upper bound which is said lowest usable frequency of the reverberation chamber, and **in that** the passive and selective elements for absorbing radiofrequencies are arranged at a distance from the side walls (13 to 16) of the enclosure (10) which is at least equal to half the wavelength corresponding to said lowest usable frequency of the reverberation chamber.

2. Reverberation chamber according to claim 1, **characterised in that** it comprises a resonant mode stirrer (4) inside the enclosure (10).

3. Reverberation chamber according to either claim 1 or claim 2, **characterised in that** the passive and selective elements for absorbing radiofrequencies comprise synthetic composite materials the transmission coefficient properties of which are frequency selective.

4. Reverberation chamber according to claim 3, **characterised in that** the passive and selective elements for absorbing radiofrequencies (5) comprise grids of periodic structure the size of the elementary patterns of which is of the order of half the wavelength of the desired absorption frequency.

5. Reverberation chamber according to claim 3, **characterised in that** the passive and selective elements for absorbing radiofrequencies (5) comprise metamaterials having matrices of patterns (51).

**6.** Reverberation chamber according to any one of claims 1 to 5, **characterised in that** the passive and selective elements for absorbing radiofrequencies comprise an absorber (61) encapsulated in stacks (62, 63) of grids of periodic structure or in metamaterials.

**7.** Reverberation chamber according to claim 5, **characterised in that** the patterns (51) are etchings of a conductive metallic material on a dielectric material and have a size which is of the order of one tenth of a wavelength corresponding to said lowest usable frequency.

**8.** Reverberation chamber according to claim 6, **characterised in that** said stack comprises two or three superposed layers (61 to 63), and the grids of periodic structure or the metamaterials comprise patterns constituted by circular or square rings.

**9.** Reverberation chamber according to any one of claims 1 to 8, **characterised in that** said lowest usable frequency is between 100 MHz and 18 GHz.

**10.** Reverberation chamber according to claim 6, **characterised in that** the absorber (61) comprises a foam which is absorbent in the microwave range.

**11.** Reverberation chamber according to claim 4 or claim 5, **characterised in that** the passive and selective elements for absorbing radiofrequencies behave like lowpass filters, on the scale of the frequency bands under consideration.

**12.** Reverberation chamber according to any one of claims 1 to 10, **characterised in that** the passive and selective elements for absorbing radiofrequencies form a spatial bandpass filter.

**13.** Reverberation chamber according to any one of claims 1 to 12, **characterised in that** the passive and selective elements for absorbing radiofrequencies comprise two-dimensional structures which are not parallel to any of the faces of the reverberation chamber which are constituted by said floor (11), said side walls (13 to 16) and said ceiling (12).

**14.** Reverberation chamber according to any one of claims 1 to 12, **characterised in that** the passive and selective elements for absorbing radiofrequencies comprise three-dimensional structures (106).

**15.** Reverberation chamber according to any one of claims 1 to 14, **characterised in that** the passive and selective elements for absorbing radiofrequencies are arranged inside the enclosure (10) in a central zone which is remote from said side walls (13 to 16) and from said ceiling (12).

FIG.1

EP 2 981 836 B1

FIG.2

FIG.3

FIG.4

FIG.5

FIG.6

FIG.7

155

105

153

152

## FIG.8A

155

105

154

160

160

151

106

153

152

156

## FIG.8B

# EP 2 981 836 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20130050006 A
- WO 2012097732 A
- FR 2906040

**Littérature non-brevet citée dans la description**

- **COZZA et al.** *Symposium on Electromagnetic Compatibility (APEMC),* 2012, 765-768
- **ZHOU et al.** *Phys. Rev. Lett.,* vol. 94, 243905
- **HUANG-L. et al.** *Progress In Electromagnetics Research,* 2011, vol. 113, 103-110
- **GAY-BALMAZ-P. et al.** *J. Appl. Phys,* 2002, vol. 92 (5), 2929-2936
- **WU-T.K.** Frequency Selective Surface and Grid Array. Wiley, 1995